Europäisches Patentamt

(19) European Patent Office    (11) Publication number: **0 161 747**

Office européen des brevets    **B1**

(12)    **EUROPEAN PATENT SPECIFICATION**

(45) Date of publication of patent specification: **11.05.88**    (51) Int. Cl.⁴: **C 30 B 23/02, C 30 B 25/02, C 30 B 31/06, C 30 B 29/10**

(21) Application number: **85301514.7**

(22) Date of filing: **05.03.85**

(54) Semiconductor production method.

(30) Priority: **08.03.84 JP 45307/84**

(43) Date of publication of application:
**21.11.85 Bulletin 85/47**

(45) Publication of the grant of the patent:
**11.05.88 Bulletin 88/19**

(84) Designated Contracting States:
**BE DE FR GB NL SE**

(56) References cited:
**US-A-3 230 044**
**US-A-3 297 403**

(73) Proprietor: **Suda, Toshikazu**
**7-3 Mitsuzawaminami-cho Kanagawa-ku**
**Yokohama-shi Kanagawa-pref. (JP)**
(73) Proprietor: **Shinanokenshi Co. Ltd.**
**1078 Kami-Maruko-machi**
**Chiisaagata-gun Nagano-pref (JP)**

(72) Inventor: **Suda, Toshikazu**
**7-3 Mitsuzawaminami-cho Kanagawa-Ku**
**Yokohama-shi Kanagawa-pref. (JP)**

(74) Representative: **Serjeant, Andrew Charles**
**25 The Crescent King Street**
**Leicester, LE1 6RX (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Technical field

The invention relates to a method of producing semi-conductors with a low density of intrinsic defects, suitable for use in such electronic devices as solar cells, sensors, lasers, transistors and diodes, from compounds between elements of Groups II and V of the Periodic Table, which compounds are described herein as II—V compounds.

### Background art

II—V compounds have come to show promise as the next generation of electronic materials. Among these, zinc phosphide (ZnP) is present in abundant deposits near the surface of the earth, and should be useful for the production of efficient solar cells, sensors, lasers and the like at low cost.

For practical application, it is necessary to overcome the problems posed by the compounds having vacancies in their unit cells. Cadmium arsenide, for example, has a pseudofluorite structure wherein the cadmium atom at every fourth lattice site constitutes a vacancy, while zinc phosphide has 8 vacancies of zinc atoms in the 40 atoms of each unit cell. Thus the compounds include numerous deep defects due to deficiences of atoms, and so up to now it has not been possible to use them in electronic devices because of their low performance.

### The invention

The method of the invention reduces the intrinsic defect level of the compounds by diffusing into them in the course of or after production hydrogen or a halogen (fluorine, chlorine, bromine or iodine) so as to fill in the atom vacancies which are the cause of the intrinsic defects. Preferred compounds are zinc phosphide and cadmium arsenide. The method of production may for example be the low-pressure vapor-phase method (physical and chemical vapor deposition), the normal-pressure vapor-phase method, the laser chemical vapor deposition (CVD), the photo-CVD, the metal organic chemical vapor deposition method, the radical beam method, the plasma CVD, the glow discharge method, the sputtering method, the ion beam method, the ion deposition method, the ion plating method, the ionized cluster beam method, the molecular beam epitaxy method, the MOMBE (metal organic molecular beam epitaxy) method, electron cyclotron resonance CVD, the atomic layer epitaxy method, or the plasma-assisted epitaxy method. The method of the invention may be performed on a semiconductor after production by the plasma method, the ion beam method, the diffusion method, the ion implantation method or the ion plating method, ion deposition method, radical beam method, or electron cyclotron resonance method. The hydrogen or halogen may be applied to a thin film or crystal of the compound by injection or diffusion, for example.

### Drawings

Figure 1 and Figure 2 are graphs of the defect level density in Schottky diodes made from zinc phosphide thin film in accordance with Example 1 below;

Figure 3 is a graph showing the current-voltage characteristics of a zinc phosphide/cadmium sulfide heterojunction solar cell in accordance with Example 2 below;

Figure 4 is a graph showing the spectral response for the solar cell of Figure 3;

Figure 5 is a graph showing the current-voltage characteristics under air mass (AM) 1 illumination of a zinc phosphide/indium-tin oxide heterojunction solar cell of Example 3 below;

Figure 6 is a graph showing the spectral response for a cadmium sulfide/zinc phosphide thin film in accordance with the invention in contrast to that of a conventional thin film of the same type; and

Figure 7 is a graph showing the current-voltage characteristics of a thin-film zinc phosphide-magnesium Schottky diode in accordance with the invention in contrast to that of a conventional diode of the same type.

### Best mode

### Example 1

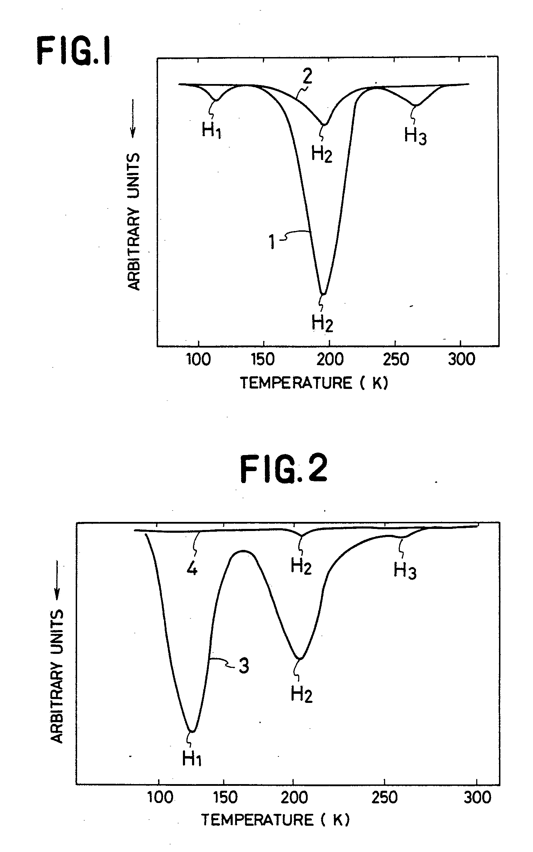

Hydrogen was diffused into a thin film of zinc phosphide during its production by low-pressure CVD. Another thin film was produced for comparison under identical conditions except that it was not hydrogenated. The thin films so obtained were used to fabricate Schottky diodes, and their defect level density was measured by deep level transient spectroscopy (DLTS) at a window rate of 128/sec. The results are in Figure 1 wherein the x-axis represents the temperature (°K) and the y-axis the defect level density (in arbitrary units). On curve 1 (for comparison), the levels $H_1$, $H_2$, $H_3$ indicate high defect density in the non-hydrogenated sample, and are the three intrinsic hole trap levels in the p-type zinc phosphide. The level $H_1$ is at 0.20 electron volt (eV), $H_2$ at 0.36 eV, and $H_3$ at 0.48 eV from the top of the valence band. The density at the level $H_1$ is $1.3 \times 10^{13}/cm^3$, at the level $H_2$ is $1.1 \times 10^{14}/cm^3$ and at the level $H_3$ is $1.1 \times 10^{13}/cm^3$. On curve 2 (the hydrogenated sample), the levels $H_1$ and $H_3$ disappear completely and the density at level $H_2$ is about 1/10 of its former magnitude.

Figure 2 shows the defect level density of second samples produced under the same conditions as the first samples above, obtained by the DLTS method at a window rate of 640/sec. On curve 3 (no hydrogenation), the densities at the levels $H_1$ and $H_2$ were $3.6 \times 10^{13}/cm^3$ and $1.6 \times 10^{13}/cm^3$ respectively. On curve 4 (hydrogenated in the course of production), the level $H_1$ disappears completely, while the density at the level $H_2$ was reduced to 1/30 of its former magnitude. The density at level $H_3$ was very small to begin with and disappeared completely after hydrogenation.

## Example 2

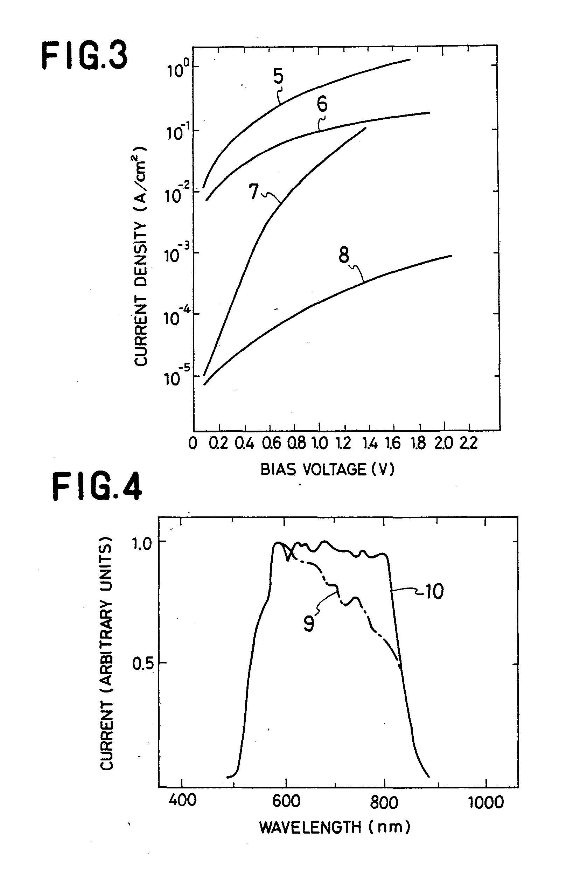

Zinc phosphide crystal was hydrogenated by the hydrogen plasma method, and cadmium sulfide (CdS) was vacuum evaporated on the resulting crystal to obtain zinc phosphide/CdS heterojunction solar cells. In Figure 3 curves 5 and 6 show the forward and reverse characteristics respectively without hydrogenation, while curves 7 and 8 show the corresponding characteristics when hydrogenation was carried out during production.

Comparison of curve 8 with curve 6 shows that the addition of hydrogen results in a reduction in leakage current in the reverse direction of the order of $10^3$. The spectral response in Figure 4, curve 9 (no hydrogenation) and curve 10 (hydrogenation), show that in the longer-wave length region the response of curve 10 is much better than for curve 9. The improvements that can be seen in Figures 3 and 4 result from the disappearance or significant reduction in the density of the hole trap levels $H_1$, $H_2$, $H_3$ described above.

## Example 3

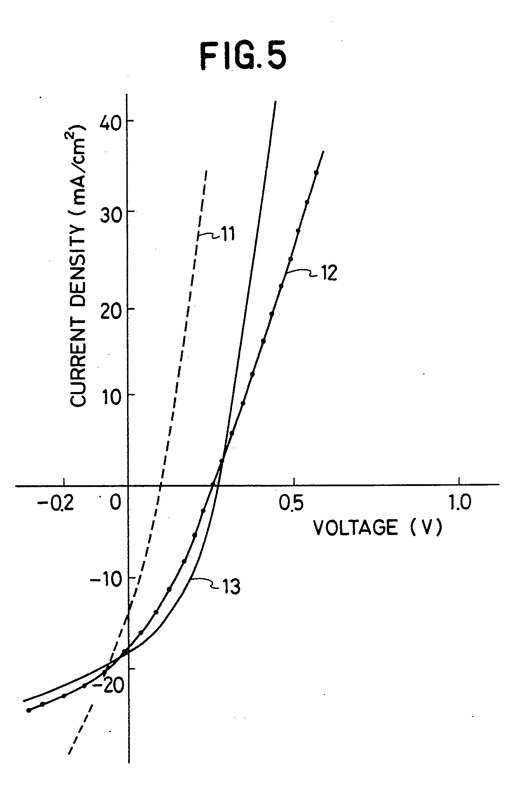

Zinc phosphide crystal was hydrogenated by the hydrogen plasma method, and indium tin oxide (ITO) was vacuum evaporated on the resulting crystal to obtain ITO/ZnP heterojunction solar cells. Generally speaking, the surface of zinc phosphide crystal has a layer largely deficient in P atoms extending to a depth of about 10 nanometers (nm) (100Å). Therefore, when zinc phosphide is to be used in an electronic device, its current-voltage characteristics can be considerably improved by removing its surface to a depth of approximately 10 nm (100Å) by sputter etching or the like. When a process of hydrogenating the zinc phosphide is carried out in addition to sputter etching, at least a 30% improvement in power conversion efficiency is achieved. There is also an increase in open-circuit voltage. The current-voltage characteristics of the solar cell in Figure 5 are under simulated AM 1 illumination (with the sun at zenith). The curve 11 is where neither sputter etching nor hydrogenation was carried out, the curve 12 only sputter etching and the curve 13 hydrogenation by the hydrogen plasma method after sputter etching. Curve 13 (according to the invention) shows a huge improvement over curve 11 and a major improvement over curve 12.

## Example 4

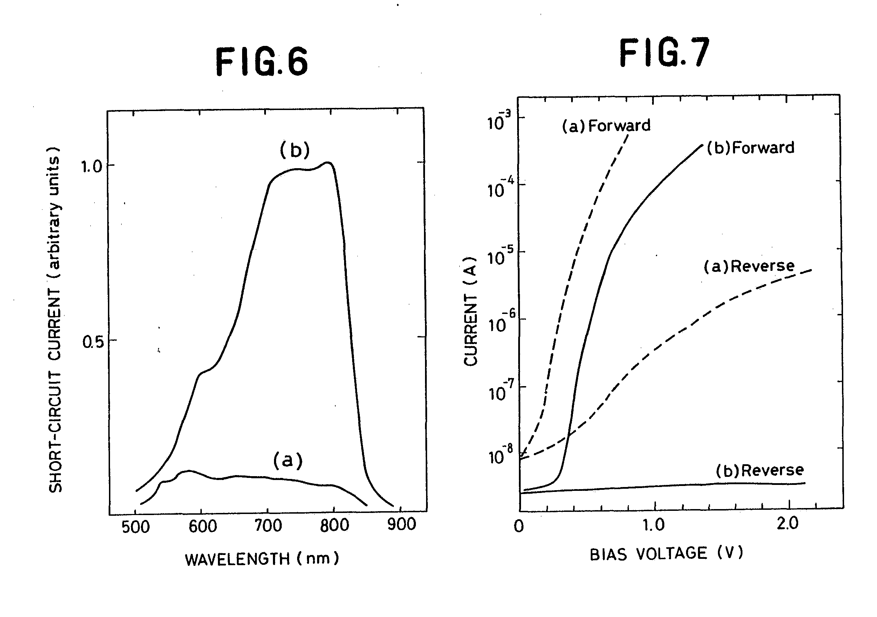

Thin films of zinc phosphide were grown by chemical vapor deposition (CVD) with and without hydrogenation, and cadmium sulfide was deposited thereon by vacuum evaporation to obtain solar cells. In Figure 6, curve (a) represents the spectral response for the solar cell made with non-hydrogenated (as grown) zinc phosphide and curve (b) the spectral response of the solar cell made with hydrogenated zinc phosphide according to the invention. Curve (b) shows the good band-pass behaviour (window effect) of the heterojunction formed by the CdS window on a ZnP thin film absorber between 500 nm and 850 nm, corresponding to the approximate bandgaps of the respective semiconductors. In the hydrogenated sample of curve (b) the signal itself is significantly improved over that of the non-hydrogenated sample of curve (a), where the response is low.

## Example 5

Thin films of zinc phosphide were grown by CVD with and without hydrogenation, and magnesium was deposited thereon by vacuum evaporation to obtain Schottky diodes with a Mg area measuring 1 mm in diameter. In Figure 7, curves (a) (dashed line) show the current-voltage characteristics, forward and reverse, for a diode made with non-hydrogenated zinc phosphide and curves (b) (solid line) show the current-voltage characteristics, forward and reverse, for a diode made with hydrogenated zinc phosphide according to the invention. The non-hydrogenated sample of curve (a) exhibits a large leakage current, resulting in poor rectification. On the other hand, the hydrogenated sample of curve (b) exhibits a significant improvement in the rectification. In the hydrogenated sample the reverse current is greatly reduced by a factor of the order of $10^3$, while in the forward current the diffusion potential is improved, providing much better rectification.

## Claims

1. A method of producing II—V compound semiconductor crystals or thin films characterized by diffusing hydrogen or a halogen into a II—V compound semiconductor in the course of or after production.

2. A method according to claim 1 in which the compound as a crystal or thin film has the diffusion of hydrogen or halogen carried out by injection and diffusion.

3. A method according to claim 1 or claim 2 wherein the production is by the low-pressure vapor-phase method (physical and chemical vapor deposition), the normal-pressure vapor-phase method, the laser chemical vapor deposition (CVD), the photo-CVD, the metal organic chemical vapor deposition method (MOCVD), the radical beam method, the plasma CVD, the glow discharge method, the sputtering method, the ion beam method, the ion plating method, the ionized cluster beam method, the ion deposition method, the molecular beam epitaxy method, the metal organic molecular beam epitaxy (MOMBE) method, electron cyclotron resonance CVD, atomic layer epitaxy method, the plasma-assisted epitaxy method, the plasma method, the diffusion method or the ion injection method.

4. A method according to any preceding claim in which the compound treated is zinc phosphide or cadmium arsenide.

## Patentansprüche

1. Verfahren zur Herstellung von II—V-Halbleiterkristallen oder Dünnfilmen, gekennzeichnet durch Diffundieren eines II—V-Halbleiters mit Wasserstoff oder Halogen während oder nach der Herstellung.

2. Verfahren gemäß Anspruch 1, wobei das Diffundieren der als Kristall oder Dünnfilm ausgebildeten Verbindung mit Wasserstoff oder Halogen durch Injektion und Diffusion erfolgt.

3. Verfahren gemäß Anspruch 1 oder Anspruch 2, wobei die Herstellung nach der Niederdruck-Dampfphasenmethode (physikalische und chemische Dampfphasenabscheidung), der Normaldruck-Dampfphasenmethode, der Laser-chemischen Dampfphasenabscheidung (CVD), der photo-chemischen Dampfphasenabscheidung (CVD), der metallorganischen chemischen Dampfphasenabscheidung (MOCVD), der Radikalstrahlmethode, der Plasma-CVD, der Glimmentladungsmethode, der Zerstäubungsmethode, der Ionenstrahlzerstäubungsmethode, der Ionengalvanisierungsmethode, der ionisierten Strahlbündelmethode, der Ionenabscheidungsmethode, der molekularen Strahlepitaxie-Methode (MOMBE), der Elektronenzyklotron-Resonanz-CVD, der Atomlagen-Epitaxie-Methode, der plasma-unterstützten Epitaxie-Methode, der Plasmamethode, der Diffusionsmethode oder der Ioneninjektionsmethode erfolgt.

4. Verfahren gemäß einem der vorhergehenden Ansprüche, wobei die behandelte Verbindung Zinkoxid oder Cadmiumarsenid ist.

**Revendications**

1. Une méthode de production de crystaux de semi-conducteur composé II—V ou des films minces caractérisés par la diffusion d'hydrogène ou un halogène dans un semi-conducteur composé II—V en cours de production ou après production.

2. Une méthode selon la revendication 1 dans laquelle le composé en tant qu'un crystal ou film mince à la diffusion d'hydrogène ou halogène effectuée par injection et diffusion.

3. Une méthode selon la revendication 1 ou la revendication 2 dans laquelle la production est faite par la méthode de phase-vapeur à basse pression (depot de vapeur physique et chimique), la méthode phase-vapeur à pression normale, le depot de vapeur chimique laser (CVD), le CVD-photo, la méthode de depot de vapeur chimique organique de métal (MOCVD), la méthode de rayon radical, le CVD plasma, la méthode de decharge de lueur, la méthode de crépitement, la méthode de faisceau ionique, la methode de revêtement ionique, la méthode de faisceau groupé ionisé, la méthode de dépôt ionique, la méthode d'epitaxie de faisceau moléculaire, la methode d'epitaxie de faisceau moléculaire organique Métal (MOMBE), le CVD de resonance de cyclotron electronique, le méthode d'epitaxie de couche atomique, la méthode plasma-assistée, la méthode plasma, ou la méthode de diffusion, la méthode d'injection ionique.

4. Une méthode selon toute revendication precendente dans laquelle le composé traité est du phosphure de zinc ou de l'arsenure de cadmium.

# FIG.1

# FIG.2

# FIG.3

CURRENT DENSITY (A/cm²)

$10^0$

$10^{-1}$

$10^{-2}$

$10^{-3}$

$10^{-4}$

$10^{-5}$

5

6

7

8

0  0.2  0.4  0.6  0.8  1.0  1.2  1.4  1.6  1.8  2.0  2.2

BIAS VOLTAGE (V)

# FIG.4

CURRENT (ARBITRARY UNITS)

1.0

0.5

10

9

400  600  800  1000

WAVELENGTH (nm)

# FIG.5

# FIG.6

# FIG.7

0 161 747